# EUROPEAN PATENT APPLICATION

(11) **EP 4 826 687 A1**
(43) Date of publication of application: **21.10.2026**
(21) Application number: 25171084.4
(22) Date of filing: 16.04.2025
(51) Int. Cl.: G07C 9/00, G07C 9/20

(54) **PROXIMITY AND TOUCH UNLOCKING SYSTEM**

(30) Priority: 15.04.2025 PT 2025120210
(71) Applicant: BBG S.A., 4740 - 473 Esposende (PT)
(72) Inventor: SOUSA ARAÚJO, Miguel, 4740-473 Esposende (PT); DUARTE, Paulo, 4910-012 Caminha (PT); RIBEIRO MACHADO, Rafael, 4740-473 Esposende (PT)

(57) **Abstract**

The present invention concerns a proximity and touch unlocking system which comprises a mobile emitting device and a fixed receiving device, the latter embedded into a frame or contact unit (1) that has an active contact area (2). The fixed device has the capacity to assess variations in electrical resistance and to receive a signal remotely. Contact between a user, for example the hand, and the active contact area (2), causes a variation in electrical resistance in this area (2) promoted by the human body; this variation is detected by the capacitive sensor of the fixed device, which in turn also detects the approach of the mobile device. When the fixed device simultaneously detects either the identification of the mobile device and the variation in electrical resistance, a locking system will receive the order to change state (from closed to open) promoting its unlocking, thus enabling the user to move the frame.

## Description

### TECHNICAL FIELD

The present invention falls within the field of keyless unlocking systems, with an unlocking component and powered by an external power source, in particular for application to frame systems.

In the context of this patent application, frame systems are understood to mean any system of frames for windows, doors, gates, etc., and these frames may be sliding or pivot systems, tilt and turn, among other frames known in the state of the art.

### BACKGROUND OF THE INVENTION

Current frame systems offer numerous manual and remote opening and locking solutions. Advances in home automation have brought a range of possibilities for opening and closing of frame systems, doors and windows of the most diverse configurations, including pivoting and sliding. These solutions are provided by wireless instructions, through window motorization and using a button for activation. Even vehicle systems include the keyless system, in which the car unlocks when the key is near. Examples of these solutions are present in the following patent documents: WO 2024/198182 A1; WO 2018234604 A1 and US 2023203854 A.

The present invention differs from all the aforementioned documents and from other solutions since it is invisible, that is, it is integrated into the frame, and to the user be able to unlock the frame, it is necessary to detect both a device that is with the user, as well as the user's contact with the object, in this case, the frame, thus promoting a level of security that does not exist in the state of the art.

### TECHNICAL PROBLEMS SOLVED AND ADVANTAGES

It would be very inconvenient for a door or window to open only when the user is nearby, without the user wanting it to open, as they may not want to open an entrance to their home unintentionally. The present invention allows us to not necessarily use a key to open the frame, we can simply have in our possession a mobile device (1) that recognizes the frame using the technology described below, but the door is only unlocked when the user simultaneously touches the frame.

The present invention is used in opening secondary passages, main entrances recommended with a "fail-safe" mechanical lock, since it is a secure opening based on contact through the detection of the unique user identification device. This solution allows us to transform an existing profile flap, commonly known as a handle, into a touch-sensitive flap that, together with a remote-control device, will unlock the system if contact is made within the range of the surface sensor.

### DESCRIPTION OF FIGURES

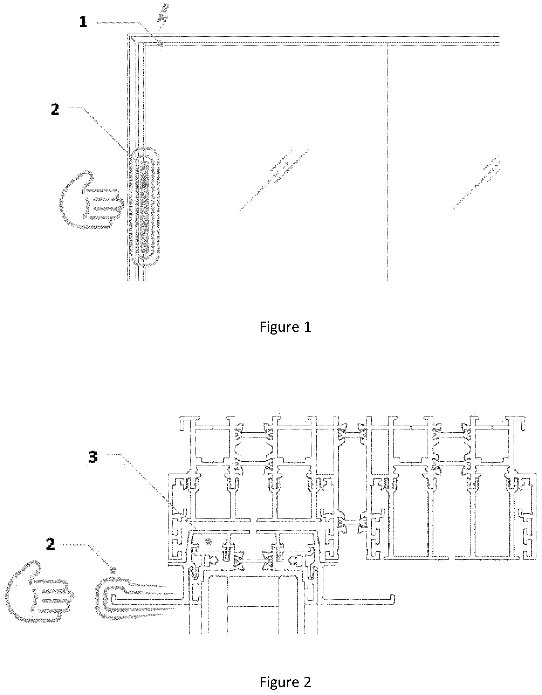

Figure 1 - Representation of the contact unit (1), in this case a window frame, and of the respective active contact area (2), in this case on the window frame handle.
Figure 2 - Representation of the active contact area (2), in this case on the door handle, of the contact unit, here a window frame, and the fixed device (3) that receives information regarding the proximity of the mobile device and contact with the user.

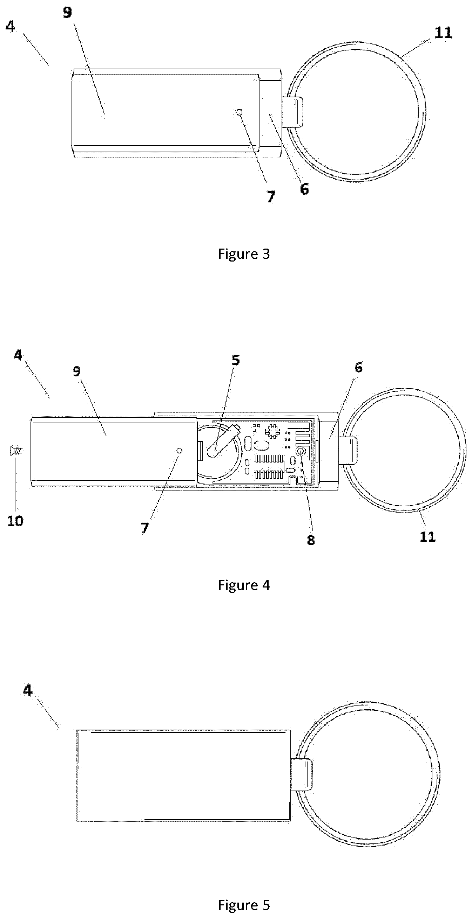

Figure 3 - Top view of the mobile device (4), showing the sliding cover (9) in a closed position, the hole (7) for viewing the light alarm, the single body (6) and a support (11).
Figure 4 - Top view of the mobile device (4), showing the sliding cover (9) in a open position, allowing to see the hole (7) for viewing the light alarm (8), the single body (6), the mobile device (4) is battery-powered, and also shows the single access screw (10) for accessing the inside of the mobile device (4), for example to repair or change the battery (5); and a support (11).
Figure 5 - Bottom view of the mobile device (4).

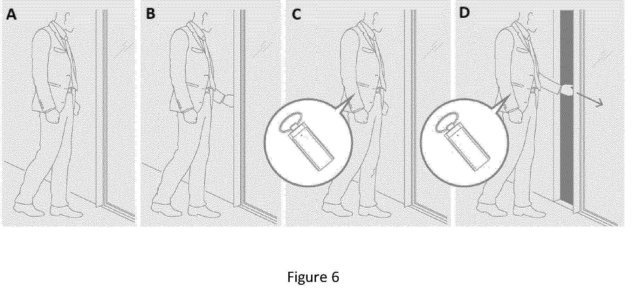

Figure 6 - representation of four situations: A - The user is close to the frame, but without contact and without the mobile device (4) having been detected, i.e., the closed frame does not unlock; B - The user is in contact with frames, but the mobile device (4) is not detected, i.e., the closed frame does not unlock; C - The mobile device (4) is detected, but there is no contact between the user and the window, i.e., the window that is closed does not unlock; and D - The mobile device (4) is detected, and the user is in contact with the window, i.e., the window that is closed is unlocked, allowing it to open.

### DETAILED DESCRIPTION

This invention relates to a proximity and touch unlocking system, which comprises a mobile device (4) and a fixed device (3). The mobile device (4) is a signal emitter, and the fixed device (3) is a receiver, which identifies the signal emitted by the mobile device (4) and also an electrical resistance. This proximity and touch unlocking system also comprises a contact unit (1), this contact unit (1) has an active contact area (2), and it is in the contact unit (1) that the fixed device (3) is embedded or integrated, as well as an active contact area (2).

The mobile device (4) has a built-in emitter, and preferably has a sliding cover (9), so that access to its interior is possible. This mobile device (4) is powered, has a light alarm component (8), which can light up when the system unlocks, so that its visualization is possible, the sliding cover (9) has a hole (7).

The fixed device (3) has at least one capacitive sensor, which is capable of evaluating variations in electrical resistance, and at least one receiver, capable of receiving a signal remotely. Contact between the user, for example the hand, and the active contact area (2), causes a variation in electrical resistance in this area (2) caused by the human touch. This variation is detected by the capacitive sensor of the fixed device (3), housed in the contact unit (1), this contact unit (1).

The fixed device (3) in turn also detects the approach of the mobile device (4), through its receiver, when the mobile device (4) enters the reading field of the receiver, which will be between 1 and 2 m from the active contact area (2).

When the fixed device (3) simultaneously detects either the identification of the mobile device (4) and the variation in electrical resistance, the locking system will receive the order to change state (from closed to open) promoting its unlocking.

In the case where the contact unit (1) is a frame system comprising at least one moving leaf, at least one fixed device (3) and at least one moving device (4) are incorporated into the moving leaf. Since the system has a locking system, a user who has with him/her the mobile device (4) and when touches the leaf in the active contact area (2) synchronises the fixed device (3) to detect proximity and assess the variation in electrical resistance, thus sending an order to the locking system to change state (from closed to open), allowing the user to move the leaf and open the window or door.

It should be added that: a) both the detection of the mobile device (4) and the contact between the user and the frame must occur by the same user to activate proximity unlocking; and b) the detection of the remote control and the user contact may occur between one or more users if they are very close to the sensory window flap.

In a preferred embodiment of the invention, the contact unit (1) is a frame, preferably made of aluminum.

In a preferred embodiment of the invention, the mobile device (4) has a single body (6), which may have means for being connected to other elements, for example placed on a key ring, or may itself be the key ring.

In a preferred embodiment of the invention, the active contact area (2) is located in an area close to the handle and at a height where the user normally places his/her hand to move the leaf. In a preferred embodiment of the invention, the active contact area (2) is the handle of the frame.

In a preferred embodiment of the invention, the light alarm (8) is a light emitting diode (LED).

In a preferred embodiment of the invention, the support (11) may be a ring for attachment, such as a key ring.

In a preferred embodiment of the invention, the single body (6) may be made of machined metal and/or may contain laser engravings for possible identification.

In a preferred embodiment of the invention, the sliding cover (9) may have engravings and protective coatings.

As will be evident to one skilled in the art, the present invention should not be limited to the embodiments described in the present document, with several modifications being possible that remain within the scope of the present invention. Evidently, the preferred modes presented above are combinable, in the different possible ways, avoiding the repetition of all these combinations.

## Claims

1. Proximity and touch unlocking system comprising:
a) at least one mobile device (4) comprising a built-in signal emitter;
b) at least one fixed device (3) comprising a built-in signal receiver from the mobile device (4) and at least one capacitive sensor, said sensor being capable of evaluate variations in electrical resistance;
c) at least one contact unit (1) embedded into the fixed device (3) and comprising at least one active contact area (2), said active contact area (2) presenting variations in electrical resistance when contacting human touch;
such that when there is synchronous detection of:
a variation in electrical resistance at the area (2) detected by the capacitive sensor of the fixed device (3), housed in the contact unit (1); and
a detection of the mobile device (4) approaching the receiver of the fixed device (3);
the proximity and touch unlocking system unlocks.

2. System according to the previous claim wherein the mobile device (4) is battery-powered and comprises: a sliding cover (9), which has an orifice (7); and a light alarm component (8).

3. System according to the previous claims wherein the mobile device (4) being a single body (6), comprising means for being connected to a support element (11).

4. System according to the previous claims wherein the light alarm (8) is a light-emitting diode.

5. System according to the previous claims wherein the support (11) is a keychain.

6. System according to the previous claims wherein the single body (6) is made of machined metal.

7. System according to the previous claims wherein the sliding cover (9) has engravings, protective coatings.

8. A frame system comprising at least one fixed frame and at least one movable leaf, said movable leaf having a handle comprising a locking system described in claims 1 to 7, the contact unit (1) being the movable leaf and the active contact area (2) being located approximately on the handle.

9. Frame system according to the previous claim wherein the active contact area (2) is the handle.

10. Frame system according to claims 8 and 9 wherein said frame is made of aluminum.
